# EUROPEAN PATENT APPLICATION

(11) **EP 3 637 969 A1**
(43) Date of publication of application: **15.04.2020**
(21) Application number: 18919708.0
(22) Date of filing: 03.12.2018
(51) Int. Cl.: H05K 7/20

(54) **HEAT DISSIPATION APPARATUS AND FREQUENCY CONVERTER**

(30) Priority: 25.05.2018 CN 201810560699
(71) Applicant: GD Midea Heating & Ventilating Equipment Co., Ltd., Foshan, Guangdong 528311 (CN); Midea Group Co., Ltd., Foshan, Guangdong 528311 (CN)
(72) Inventor: CHEN, Tujin, Foshan, Guangdong 528311 (CN); CAO, Dan, Foshan, Guangdong 528311 (CN); YANG, Kun, Foshan, Guangdong 528311 (CN)
(74) Representative: RGTH
(86) International application number: PCT/CN2018/118952
(87) International publication number: WO 2019/223285

(57) **Abstract**

Provided are a heat dissipation apparatus (1) and a frequency converter. The heat dissipation apparatus (1) includes: a base plate (10); a plurality of flow channels (20), arranged in the base plate (10) and respectively penetrating a first side wall (102) and a second side wall (104) of the base plate (10) in a non-overlapping manner; an inlet flow guide assembly (30), connected to the first side wall (102) and in communication with the plurality of flow channels (20); and an outlet flow guide assembly (40), connected to the second side wall (104) and in communication with the plurality of flow channels (20).

## Description

### CROSS-REFERENCE TO RELATED DISCLOSURE

The present disclosure is based on and claims priority to Chinese Patent Disclosure Serial No. 201810560699.5, filed on May 25, 2018, the entire contents of which are incorporated herein by reference.

### FIELD

The present disclosure relates to a technical field of electronic appliances, and in particular, to a heat dissipation apparatus and a frequency converter.

### BACKGROUND

With the continuous development of technology, the market is increasingly demanding on the performance and power density of frequency converters, and in turn becomes extremely demanding on heat dissipation of power modules of frequency converters. Insulated gate bipolar transistors (IGBT) and diodes (a rectifier bridge) in power modules are high-frequency and high-power devices, for which the main heat dissipation methods include air cooling and liquid cooling (mainly water cooling). In the related art, flow channels of a heat dissipation apparatus for liquid cooling adopts a serial structure, or an inlet and an outlet for a cooling liquid located on the same side of the heat dissipation apparatus in order to extend the flow channel. However, the structure of the above flow channel mainly involves the following defects.
1. The long flow channel and large resistance result in a poor heat dissipation ability under the same driving pressure. From the inlet to the outlet of the flow channel, the coolant temperature continues to increase, which affects the heat dissipation of the power modules downstream of the flow channel, and may easily cause a relatively large temperature difference among the power modules, thereby degrading the operational reliability of the product.
2. In order to evade mounting holes of the power modules and ensure the structural strength between the flow channels, the density of the flow channels is too small, so that a total area of the flow channels is small, that is, a contact area with the power modules is small, thereby resulting in a poor heat dissipation effect.

### SUMMARY

The present disclosure aims to solve at least one of the technical problems in the prior art or the related art.

Accordingly, a first aspect of the present disclosure proposes a heat dissipation apparatus.

A second aspect of the present disclosure proposes a frequency converter.

To this end, the present application proposes a heat dissipation apparatus for a frequency converter. The heat dissipation apparatus includes: a base plate; a plurality of flow channels provided in the base plate, and penetrating a first side wall and a second side wall of the base plate, without overlapping each other; an inlet flow guide assembly connected to the first side wall and communicated with the plurality of flow channels; and an outlet flow guide assembly connected to the second side wall and communicated with the plurality of flow channels.

The heat dissipation apparatus proposed in the present disclosure includes: the base plate, the plurality of flow channels, the inlet flow guide assembly, and the outlet flow guide assembly. A flow path of a cooling liquid in the heat dissipation apparatus is from the inlet flow guide assembly through the plurality of flow channels of the base plate to the outlet flow guide assembly. Further, since the plurality of flow channels do not overlap each other and penetrate the first side wall and the second side wall of the base plate respectively, that is, the plurality of flow channels are arranged within the base plate in a parallel manner, the positions of the plurality of flow channels can be adjusted according to specific actual conditions, in order to increase the arrangement density of the flow channels, thereby enlarging the total heat dissipation area and greatly improving the heat dissipation performance of the product. At the same time, since the plurality of flow channels penetrate the first side wall and the second side wall of the base plate respectively, that is, the cooling liquid flows in through inlets of the plurality of flow channels on a first side of the base plate and flows out through outlets of the plurality of flow channels on a second side of the base plate, each flow channel has a short flow path. In this way, the temperature difference of the cooling liquid at both ends of the flow channel is small, and the temperature difference between devices to be heat-dissipated at the both ends of the flow channel is reduced, thereby ensuring the balance of the heat dissipation effect at various positions of the heat dissipation apparatus, and avoiding the occurrence of reducing the operational performance of the devices to be heat-dissipated due to an excessive temperature difference of the cooling liquid at various positions, so as to enhance the reliability and stability of the devices to be heat-dissipated, and prolong the service life of the devices to be heat-dissipated. Further, the parallel arrangement of the plurality of flow channels can offset the flow pressure generated when the cooling liquid flows through the flow channels. Specifically, the arrangement density of the flow channels can be increased and the cross-sectional area of the flow channels can be reduced, in which way the pressure generated when the cooling liquid flows is further reduced. Thus, the wall thickness of the flow channels can be reduced while the smoothness and stability of the cooling liquid flow is ensured, thereby further increasing an area of the flow channels through which the cooling liquid flows per unit time, that is, enlarging a contact area between the heat dissipation apparatus and the devices to be heat-dissipated, improving the working efficiency of the product, and reducing the energy consumption. At the same time, the parallel arrangement reduces a bending area of the plurality of flow channels, facilitates the reasonable layout of the flow channels, reduces the processing difficulty, and lowers the probability of damage at the bends due to excessive flow pressure, thereby extending the service life of the heat dissipation apparatus. Further, the installation positions of the inlet flow guide assembly and the outlet flow guide assembly can be adjusted according to the actual situations. Hence, the reasonable layout of other components of the frequency converter can be achieved while the smooth flow of the cooling liquid is ensured, the space occupation rate of the heat dissipation apparatus to the frequency converter is decreased, the external size and weight of the frequency converter is reduced, and the performance and market competitiveness of the product is enhanced.

The heat dissipation apparatus according to the present disclosure can have the additional technical features as follows.

In the above technical solution, preferably, the inlet flow guide assembly includes: a collecting tube, the first side wall being inserted in a first opening of the collecting tube; a distribution tube having a first end penetrating the collecting tube; a plurality of distribution ports provided in the distributing tube and arranged corresponding to the first opening; a first end cap covering a first end of the collecting tube, the first end of the distribution tube abutting against an inner bottom wall of the first end cap; and a second end cap passing through a second end of the distribution tube and covering a second end of the collecting tube.

In this technical solution, the inlet flow guide assembly includes the collecting tube, the distribution tube, the plurality of distribution ports, the first end cap, and the second end cap. By disposing the plurality of distribution ports on the distribution tube and corresponding to the first opening, after the cooling liquid enters the inlet flow guide assembly from the distribution tube, the cooling liquid is sprayed out of the distribution tube from the plurality of distribution ports, and then flows into the plurality of flow channels of the base plate. Since the plurality of distribution ports are corresponding to the first opening, the flow path of the cooling liquid in the distribution tube and the base plate is shortened, so that the cooling liquid in the distribution tube can flow into the plurality of flow channels in time, which reduces the energy loss of the cooling liquid and improves the heat dissipation efficiency of the product. Further, by providing the collecting tube, and disposing the first opening on the collecting tube, after the first side wall of the base plate is inserted into the first opening, a junction between the collecting tube and the first side wall can be sealed by soldering. Such a structural arrangement increases the area at the junction between the collecting tube and the first side wall, which facilitates the stacking of solder and reduces the assembling difficulty. Moreover, since the first side wall is inserted into the first opening, a limiting function can be realized, and the material thickness at the junction between the first side wall and the collecting tube is increased, improving the structural strength at the junction, and ensuring the reliability and stability of the product. Meanwhile, the collecting tube can play a role of collecting and releasing pressure, and slow down the flow velocity of the cooling liquid, thereby allowing the cooling liquid to flow into the plurality of flow channels of the base plate smoothly, reducing the force acting on the inlet flow guide assembly when the cooling liquid is flowing, and prolonging the service life of the product. Further, the synchronization, stability and reliability of assembling the collecting tube and the distribution tube are achieved by the first end cap and the second end cap, and the first end cap and the second end cap function to seal the collecting tube and the distribution tube, so as to avoid the leakage of the cooling liquid. Specifically, by providing the plurality of distribution ports, the cooling liquid can be sprayed in all directions, angles, and dimensions, that is, the cooling liquid can be allowed to flow into the plurality of flow channels almost simultaneously, thereby ensuring the uniformity and consistency of the cooling fluid flowing into the plurality of flow channels, and ensuring uniform heat dissipation of the devices to be heat-dissipated at different positions of the heat dissipation apparatus.

In any one of the above technical solutions, preferably, the first end cap is provided with a two-step groove recessed in a direction away from the collecting tube, an end surface of the first end of the collecting tube abuts against a stepped surface of the two-step groove, and an end surface of the first end of the distribution tube abuts against an inner bottom wall of a secondary groove of the two-step groove; a flange is provided at a junction between an outer wall of the second end cap and the distribution tube.

In this technical solution, by providing the two-step groove in the first end cap, and making the end surface of the first end of the collecting tube abut against the stepped surface of the two-step groove and the end surface of the first end of the distribution tube abut against the inner bottom wall of the secondary groove of the two-step groove, the leakage of the cooling liquid from the first end of the collecting tube and the first end of the distribution tube is avoided. At the same time, the structure of the two-step groove realizes that the first end cap limits the positions of the distribution tube and the collecting tube simultaneously, reduces the shaking amount of the distribution tube relative to the collecting tube, and ensures the stability and reliability of the assembled structures. At the same time, the structure of the two-step groove is convenient for processing and mass production at a low production cost. By providing the flange at the junction between the outer wall of the second end cap and the distribution tube, the structural strength at the junction between the second end cap and the distribution tube is enhanced, and the probability of breakage of the distribution tube is reduced. At the same time, the structure of the flange facilitates the soldering of the second end cap and the distribution tube, ensures the stacking area of the solder, and improves the assembling stability and reliability.

In any one of the above technical solutions, preferably, the outlet flow guide assembly includes: a flow guide tube, the second side wall being inserted in a second opening of the flow guide tube; and a third end cap covering a first end of the flow guide tube.

In this technical solution, the outlet flow guide assembly includes the flow guide tube and the third end cap. By providing the second opening in the flow guide tube, after the second side wall of the base plate is inserted into the second opening, a junction between the flow guide tube and the second side wall can be sealed by soldering. Such a structural arrangement increases an area at the junction between the flow guide tube and the second side wall, facilitates the stacking of solder, and reduces the assembling difficulty. Moreover, since the second side wall is inserted into the second opening, the second side wall can be limited, and the material thickness at the junction between the second side wall and the flow guide tube is increased, improving the structural strength at the junction, and ensuring the reliability and stability of the product. Meanwhile, the flow guide tube can play a role of guiding flow and releasing pressure, and slow down the flow velocity of the cooling liquid, such that the cooling liquid can flow from the plurality of flow channels into the flow guide tube and then flow out of the outlet flow guide assembly smoothly. This structure reduces the force acting on the outlet flow guide assembly during the flow of the cooling liquid, and prolongs the service life of the product. Further, by providing the third end cap, and making the third end cap cover the first end of the flow guide tube to seal the flow guide tube, the leakage of the cooling liquid can be avoided.

In any one of the above technical solutions, preferably, the base plate and the plurality of flow channels are of an integrated structure.

In this technical solution, the base plate and the plurality of flow channels are of the integrated structure that has good mechanical properties, which can ensure the strength of the connection between the base plate and the plurality of flow channels. In addition, the base plate and the plurality of flow channels are integrally made to improve the production efficiency of the product and reduce the production and processing costs of the product.

In the related art, the base plate is configured to have a split structure, the flow channels are processed on an upper cover of the base plate by milling, and then the upper cover and a lower cover of the base plate are soldered together by soldering. This structure involves a lot of milling processing, wastes materials, and has long processing time and a large soldering area, which requires high soldering quality and high production costs. When the cooling liquid flows through the flow channel, it is easy to cause the leakage of the cooling liquid due to high pressure. Moreover, the flow channel processed by milling is prone to residual burrs and impurities. As a result, it is easy to block a filter mesh of the heat dissipation apparatus and cause high maintenance costs. At the same time, the structure of the base plate has to use fasteners to assemble the base plate with the inlet flow guide assembly and the outlet flow guide assembly. In this way, the thickness at the junctions between the base plate and the inlet flow guide assembly and the outlet flow guide assembly is increased, and hence the weight of the product is increased.

However, in this embodiment, with a reasonable arrangement, the plurality of flow channels are processed on the base plate by using an extrusion molding method, so that the base plate and the plurality of flow channels have the integrated structure without milling the flow channels and subsequent soldering and assembling processes. Thus, the processing technique is simple, along with less material consumption and reduced production costs. Little residue exists in the flow channels formed by the extrusion molding, thereby reducing the possibility of subsequent clogging of the filter mesh. Further, the integrated structure achieves high structural strength at the junction between the flow channels and the base plate, so that the cooling liquid will not break through the junction between the flow channels and the base plate due to the large flow pressure of the cooling liquid, and the leakage of the cooling liquid is avoided. Specifically, the base plate is assembled with the inlet flow guide assembly and the outlet flow guide assembly by plugging and soldering, which reduces the thickness at the junctions between the base plate and the inlet flow guide assembly and the outlet flow guide assembly, reduces the weight of the product, and improves the performance and market competitiveness of the product.

In any one of the above technical solutions, preferably, the heat dissipation apparatus further includes corrugations, which are evenly distributed on inner side walls or part of the inner side walls of the plurality of flow channels.

In this technical solution, by providing the corrugations, and evenly distributing the corrugations on the inner side walls or part of the inner side walls of the plurality of flow channels, a heat exchange area between the cooling liquid and the heat dissipation apparatus is increased, and the heat dissipation efficiency of the product is enhanced. Specifically, when the cross section of the outer wall of the flow channel is square, corrugations are provided on inner walls of two opposite sides of the square flow channel; certainly, the corrugations can be evenly distributed on the inner walls of the square flow channel. For another example, when the cross section of the outer wall of the flow channel is pentagonal, and the corrugations are evenly distributed on any two inner walls of the pentagonal flow channel, and so on.

In any one of the above technical solutions, preferably, the heat dissipation apparatus further includes a flow guide groove provided on a top end of the base plate, wherein the top end is an end of the heat dissipation apparatus connected to a device to be heat-dissipated.

In this technical solution, the flow guide groove is provided on the top end of the base plate, and the devices to be heat-dissipated are mounted on the top end of the heat dissipation apparatus, so that when the frequency converter works, condensation will occur under extreme working conditions, and at this time, the condensation will flow into the flow guide groove along the devices to be heat-dissipated and then flows out of the heat dissipation apparatus under the guidance of the flow guide groove. The structure of the flow guide groove restricts the flow path of the condensation, so that the condensation can flow out of the heat dissipation apparatus in accordance with a preset path, thereby ensuring a dry working environment of the devices to be heat-dissipated.

In any one of the above technical solutions, preferably, the heat dissipation apparatus further includes: a first connection hole provided in the top end, a first fastener passing through the device to be heat-dissipated and being locked in the first connection hole, so as to assemble the heat dissipation apparatus and the device to be heat-dissipated together; and a second connection hole provided in the top end, a second fastener passing through the second connection hole and being locked in a casing of the frequency converter, so as to assemble the heat dissipation apparatus and the casing together.

In this technical solution, by providing the first connection hole and the second connection hole in the top end of the base plate, the first fastener passes through the device to be heat-dissipated and is locked in the first connection hole to assemble the heat dissipation apparatus and the device to be heat-dissipated together; and the second fastener passes through the second connection hole and is locked in the casing of the frequency converter to assemble the heat dissipation apparatus and the casing together. Hence, the casing, the heat dissipation apparatus, and the device to be heat-dissipated can be assembled together stably and reliably. Meanwhile, such a structure facilitates the installation and the subsequent disassembly and maintenance. Specifically, the first connection hole is a first screw hole, and the second connection hole is a second screw hole.

In any one of the above technical solutions, preferably, the first side wall and the second side wall are located on two opposite sides of the base plate respectively.

In this technical solution, the first side wall and the second side wall are arranged appropriately, so that the first side wall and the second side wall are located on two opposite sides of the base plate respectively, thus simplifying the processing technique of the flow channels, reducing the bends of the flow channels, and increasing the density of the flow channels.

The frequency converter proposed by the second aspect of the present disclosure includes a power module; and the heat dissipation apparatus described in any one of the technical solutions of the first aspect. The power module is connected to a top end of the heat dissipation apparatus.

Since the frequency converter proposed by the present disclosure include the power module and the heat dissipation apparatus as described by the first aspect, the frequency converter has all the beneficial effects of the heat dissipation apparatus described above, which will not be elaborated in detail.

Additional aspects and advantages of embodiments of the present disclosure will become apparent in part from the following descriptions, or be learned from the practice of the embodiments of the present disclosure.

### BRIEF DESCRIPTION OF THE DRAWINGS

These and/or additional aspects and advantages of embodiments of the present disclosure will become apparent and more readily appreciated from the following descriptions made with reference to the drawings, in which:
FIG. 1 is a schematic view of a heat dissipation apparatus according to one embodiment of the present disclosure.
FIG. 2 is a front view of a heat dissipation apparatus according to one embodiment of the present disclosure.
FIG. 3 is a sectional view of the heat dissipation apparatus according to the embodiment shown in Fig. 2 along A-A.
FIG. 4 is a partially enlarged view of part C of the heat dissipation apparatus according to the embodiment shown in Fig. 3.
FIG. 5 is a sectional view of the heat dissipation apparatus according to the embodiment shown in Fig. 2 along B-B.
FIG. 6 is an exploded view of a heat dissipation apparatus according to one embodiment of the present disclosure.
FIG. 7 is a schematic view of a heat dissipation apparatus and a power module according to one embodiment of the present disclosure.

### Reference numerals:

1 heat dissipation apparatus, 10 base plate, 102 first side wall, 104 second side wall, 20 flow channel, 30 inlet flow guide assembly, 302 collecting tube, 304 first opening, 306 distribution tube, 308 distribution port, 310 first end cap, 312 second end cap, 314 two-step groove, 40 outlet flow guide assembly, 402 flow guide tube, 404 second opening, 406 third end cap, 50 corrugation, 60 flow guide groove, 70 first connection hole, 80 second connection hole, 2 power module.

### DETAILED DESCRIPTION

In order to understand the foregoing objectives, features, and advantages of the present disclosure more clearly, the present disclosure is described in further detail below with reference to the accompanying drawings and specific embodiments. It should be noted that, in the case of no conflict, the embodiments of the present disclosure and the features in the embodiments can be combined with each other.

In the following description, many specific details are set forth in order to fully understand the present disclosure. However, the present disclosure can also be implemented in other ways than those described herein. Therefore, the protection scope of the present disclosure is not limited to the specific embodiments disclosed below.

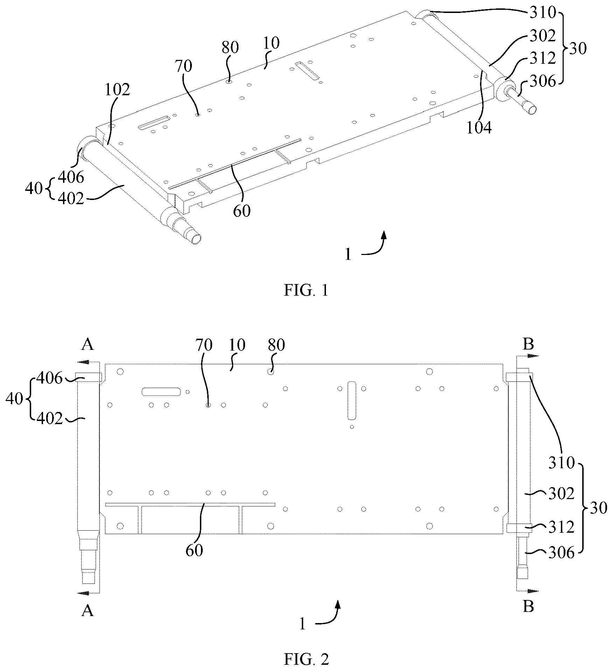

A heat dissipation apparatus 1 and a frequency converter according to some embodiments of the present disclosure will be described below with reference to FIGS. 1 to 7.

As shown in FIG. 1, FIG. 2, FIG. 4, and FIG. 6, an embodiment of the present disclosure proposes a heat dissipation apparatus 1 used for a frequency converter. The heat dissipation apparatus 1 includes: a base plate 10; a plurality of flow channels 20 provided within the base plate 10, and respectively penetrating a first side wall 102 and a second side wall 104 of the base plate 10, without overlapping each other; an inlet flow guide assembly 30 connected to the first side wall 102 and communicated with the plurality of flow channels 20; and an outlet flow guide assembly 40 connected to the second side wall 104 and communicated with the plurality of flow channels 20.

The heat dissipation apparatus 1 provided in the present disclosure includes: the base plate 10, the plurality of flow channels 20, the inlet flow guide assembly 30, and the outlet flow guide assembly 40. A flow path of a cooling liquid in the heat dissipation apparatus 1 is from the inlet flow guide assembly 30 through the plurality of flow channels 20 of the base plate 10 to the outlet flow guide assembly 40. Further, since the plurality of flow channels 20 do not overlap each other and penetrate the first side wall 102 and the second side wall 104 of the base plate 10 respectively, that is, the plurality of flow channels 20 are arranged within the base plate 10 in a parallel manner, the positions of the plurality of flow channels 20 can be adjusted according to specific actual conditions, in order to increase the arrangement density of the flow channels 20, thereby enlarging the total heat dissipation area and greatly improving the heat dissipation performance of the product. At the same time, since the plurality of flow channels 20 penetrate the first side wall 102 and the second side wall 104 of the base plate 10 respectively, that is, the cooling liquid flows in through inlets of the plurality of flow channels 20 on a first side of the base plate 10 and flows out through outlets of the plurality of flow channels 20 on a second side of the base plate 10, each flow channel 20 has a short flow path. In this way, the temperature difference of the cooling liquid at both ends of the flow channel 20 is small, and the temperature difference between devices to be heat-dissipated at the both ends of the flow channel 20 is reduced, thereby ensuring the balance of the heat dissipation effect at various positions of the heat dissipation apparatus 1, and avoiding the occurrence of reducing the operational performance of the devices to be heat-dissipated due to an excessive temperature difference of the cooling liquid at various positions, so as to enhance the reliability and stability of the devices to be heat-dissipated, and prolong the service life of the devices to be heat-dissipated. Further, the parallel arrangement of the plurality of flow channels 20 can offset the flow pressure generated when the cooling liquid flows through the flow channels 20. Specifically, the arrangement density of the flow channels 20 can be increased and the cross-sectional area of the flow channels 20 can be reduced, in which way the pressure generated when the cooling liquid flows is further reduced. Thus, the wall thickness of the flow channels 20 can be reduced while the smoothness and stability of the cooling liquid flow is ensured, thereby further increasing an area of the flow channels 20 through which the cooling liquid flows per unit time, that is, enlarging a contact area between the heat dissipation apparatus 1 and the devices to be heat-dissipated, improving the working efficiency of the product, and reducing the energy consumption. At the same time, the parallel arrangement reduces a bending area of the plurality of flow channels 20, facilitates the reasonable layout of the flow channels 20, reduces the processing difficulty, and lowers the probability of damage at the bends due to excessive flow pressure, thereby extending the service life of the heat dissipation apparatus 1. Further, the installation positions of the inlet flow guide assembly 30 and the outlet flow guide assembly 40 can be adjusted according to the actual situations. Hence, the reasonable layout of other components of the frequency converter can be achieved while the smooth flow of the cooling liquid is ensured, the space occupation rate of the heat dissipation apparatus 1 to the frequency converter is decreased, the external size and weight of the frequency converter is reduced, and the performance and market competitiveness of the product is enhanced.

In a specific embodiment, the base plate 10 is a rectangular base plate, and the thickness of the base plate 10 is smaller than the width of the base plate 10, thereby achieving the flattening of the base plate 10, and further ensuring the heat dissipation effect of the heat dissipation apparatus 1 while realizing the structural arrangement of micro-channels. The external size of the heat dissipation apparatus 1 is reduced, the space occupation rate of the heat dissipation apparatus 1 to the frequency converter is reduced, and the performance and market competitiveness of the product is improved. Certainly, the base plate 10 may also be a polygonal flat base plate, such as a pentagonal base plate, a hexagonal base plate, or the like.

In a specific embodiment, the density of the flow channels 20 in a central position of the heat dissipation apparatus 1 can be increased according to specific situations, and the density of the flow channels 20 at the edge of the heat dissipation apparatus 1 can be reduced, which improves the adaptability of the product and enriches the functionality of the product.

In a specific embodiment, the shape of the flow channel 20 can be set according to actual situations, and for example, a cross section of an outer wall of the flow channel 20 is circular, triangular, rectangular, square, pentagonal, and the like.

In an embodiment of the present disclosure, preferably, as shown in FIG. 1 to FIG. 6, the inlet flow guide assembly 30 includes a collecting tube 302, the first side wall 102 being inserted in a first opening 304 of the collecting tube 302; a distribution tube 306 having a first end penetrating the collecting tube 302; a plurality of distribution ports 308 provided on the distributing tube 306 and arranged corresponding to the first opening 304; a first end cap 310 covering a first end of the collecting tube 302, the first end of the distribution tube 306 abutting against an inner bottom wall of the first end cap 310; and a second end cap 312 passing through a second end of the distribution tube 306 and covering a second end of the collecting tube 302.

In this embodiment, the inlet flow guide assembly 30 includes the collecting tube 302, the distribution tube 306, the plurality of distribution ports 308, the first end cap 310, and the second end cap 312. By disposing the plurality of distribution ports 308 on the distribution tube 306 and corresponding to the first opening 304, after the cooling liquid enters the inlet flow guide assembly 30 from the distribution tube 306, the cooling liquid is sprayed out of the distribution tube 306 from the plurality of distribution ports 308, and then flows into the plurality of flow channels 20 of the base plate 10. Since the plurality of distribution ports 308 are corresponding to the first opening 304, the flow path of the cooling liquid in the distribution tube 306 and the base plate 10 is shortened, so that the cooling liquid in the distribution tube 306 can flow into the plurality of flow channels 20 in time, which reduces the energy loss of the cooling liquid and improves the heat dissipation efficiency of the product. Further, by providing the collecting tube 302, and disposing the first opening 304 on the collecting tube 302, after the first side wall 102 of the base plate 10 is inserted into the first opening 304, a junction between the collecting tube 302 and the first side wall 102 can be sealed by soldering. Such a structural arrangement increases the area at the junction between the collecting tube 302 and the first side wall 102, which facilitates the stacking of solder and reduces the assembling difficulty. Moreover, since the first side wall 102 is inserted into the first opening 304, a limiting function can be realized, and the material thickness at the junction between the first side wall 102 and the collecting tube 302 is increased, improving the structural strength at the junction, and ensuring the reliability and stability of the product. Meanwhile, the collecting tube 302 can play a role of collecting and releasing pressure, and slow down the flow velocity of the cooling liquid, thereby allowing the cooling liquid to flow into the plurality of flow channels 20 of the base plate 10 smoothly, reducing the force acting on the inlet flow guide assembly 30 when the cooling liquid is flowing, and prolonging the service life of the product. Further, the synchronization, stability and reliability of assembling the collecting tube 302 and the distribution tube 306 are achieved by the first end cap 310 and the second end cap 312, and the first end cap 310 and the second end cap 312 function to seal the collecting tube 302 and the distribution tube 306, so as to avoid the leakage of the cooling liquid. Specifically, by providing the plurality of distribution ports 308, the cooling liquid can be sprayed in all directions, angles, and dimensions, that is, the cooling liquid can be allowed to flow into the plurality of flow channels 20 almost simultaneously, thereby ensuring the uniformity and consistency of the cooling fluid flowing into the plurality of flow channels 20, and ensuring uniform heat dissipation of the devices to be heat-dissipated at different positions of the heat dissipation apparatus 1.

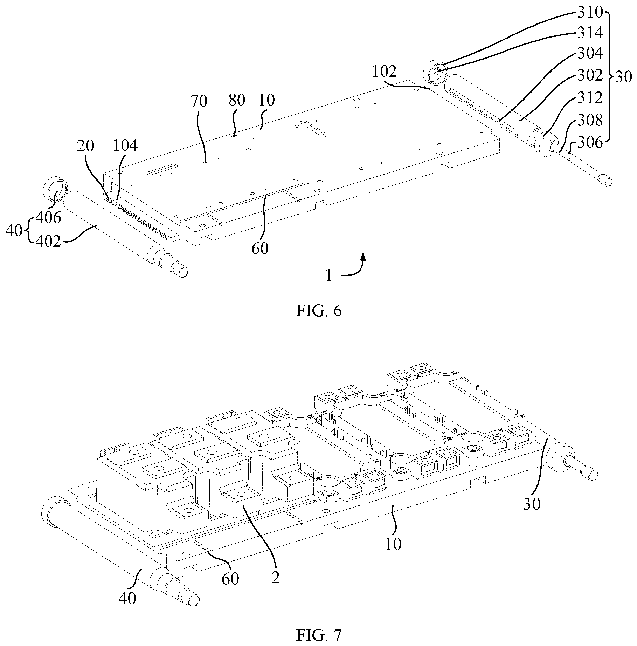

In an embodiment of the present disclosure, preferably, as shown in FIG. 6, the first end cap 310 is provided with a two-step groove 314 recessed in a direction away from the collecting tube 302, an end surface of the first end of the collecting tube 302 abuts against a stepped surface of the two-step groove 314, and an end surface of the first end of the distribution tube 306 abuts against an inner bottom wall of a secondary groove of the two-step groove 314; a flange is provided at a junction between an outer wall of the second end cap 312 and the distribution tube 306.

In this embodiment, by providing the two-step groove 314 in the first end cap 310, and making the end surface of the first end of the collecting tube 302 abut against the stepped surface of the two-step groove 314 and the end surface of the first end of the distribution tube 306 abut against the inner bottom wall of the secondary groove of the two-step groove 314, the leakage of the cooling liquid from the first end of the collecting tube 302 and the first end of the distribution tube 306 is avoided. At the same time, the structure of the two-step groove 314 realizes that the first end cap 310 limits the positions of the distribution tube 306 and the collecting tube 302 simultaneously, reduces the shaking amount of the distribution tube 306 relative to the collecting tube 302, and ensures the stability and reliability of the assembled structures. At the same time, the structure of the two-step groove 314 is convenient for processing and mass production at a low production cost. By providing the flange at the junction between the outer wall of the second end cap 312 and the distribution tube 306, the structural strength at the junction between the second end cap 312 and the distribution tube 306 is enhanced, and the probability of breakage of the distribution tube 306 is reduced. At the same time, the structure of the flange facilitates the soldering of the second end cap 312 and the distribution tube 306, ensures the stacking area of the solder, and improves the assembling stability and reliability.

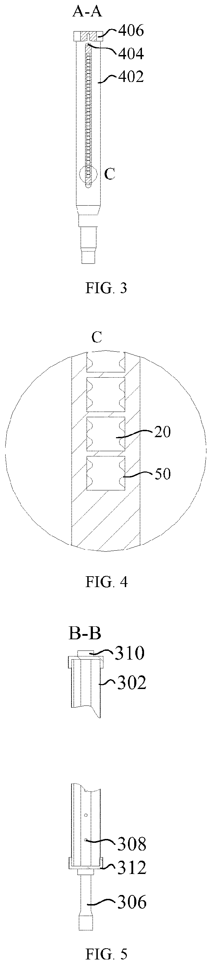

In an embodiment of the present disclosure, preferably, as shown in FIGS. 3 and 6, the outlet flow guide assembly 40 includes a flow guide tube 402, the second side wall 104 being inserted in a second opening 404 of the flow guide tube 402; and a third end cap 406 covering a first end of the flow guide tube 402.

In this embodiment, the outlet flow guide assembly 40 includes the flow guide tube 402 and the third end cap 406. By providing the second opening 404 in the flow guide tube 402, after the second side wall 104 of the base plate 10 is inserted into the second opening 404, a junction between the flow guide tube 402 and the second side wall 104 can be sealed by soldering. Such a structural arrangement increases an area at the junction between the flow guide tube 402 and the second side wall 104, facilitates the stacking of solder, and reduces the assembling difficulty. Moreover, since the second side wall 104 is inserted into the second opening 404, the second side wall 104 can be limited, and the material thickness at the junction between the second side wall 104 and the flow guide tube 402 is increased, improving the structural strength at the junction, and ensuring the reliability and stability of the product. Meanwhile, the flow guide tube 402 can play a role of guiding flow and releasing pressure, and slow down the flow velocity of the cooling liquid, such that the cooling liquid can flow from the plurality of flow channels 20 into the flow guide tube 402 and then flow out of the outlet flow guide assembly 40 smoothly. This structure reduces the force acting on the outlet flow guide assembly 40 during the flow of the cooling liquid, and prolongs the service life of the product. Further, by providing the third end cap 406, and making the third end cap 406 cover the first end of the flow guide tube 402 to seal the flow guide tube 402, the leakage of the cooling liquid can be avoided.

Specifically, the third end cap 406 and the flow guide tube 402 are of an integrated structure, and the integrated structure has good mechanical properties, which can ensure the strength of the connection between the third end cap 406 and the flow guide tube 402. In addition, the third end cap 406 is integrally made with the flow guide tube 402 and is mass-produced to improve the production efficiency of the product and reduce the production and processing costs of the product.

In an embodiment of the present disclosure, preferably, the base plate 10 and the plurality of flow channels 20 are of an integrated structure.

In this embodiment, the base plate 10 and the plurality of flow channels 20 are of the integrated structure that has good mechanical properties, which can ensure the strength of the connection between the base plate 10 and the plurality of flow channels 20. In addition, the base plate 10 and the plurality of flow channels 20 are integrally made to improve the production efficiency of the product and reduce the production and processing costs of the product.

In the related art, the base plate 10 is configured to have a split structure, the flow channels 20 are processed on an upper cover of the base plate 10 by milling, and then the upper cover and a lower cover of the base plate 10 are soldered together by soldering. This structure involves a lot of milling processing, wastes materials, and has long processing time and a large soldering area, which requires high soldering quality and high production costs. When the cooling liquid flows through the flow channel 20, it is easy to cause the leakage of the cooling liquid due to high pressure. Moreover, the flow channel 20 processed by milling is prone to residual burrs and impurities. As a result, it is easy to block a filter mesh of the heat dissipation apparatus 1 and cause high maintenance costs. At the same time, the structure of the base plate 10 has to use fasteners to assemble the base plate 10 with the inlet flow guide assembly 30 and the outlet flow guide assembly 40. In this way, the thickness at the junctions between the base plate 10 and the inlet flow guide assembly 30 and the outlet flow guide assembly 40 is increased, and hence the weight of the product is increased.

However, in this embodiment, with a reasonable arrangement, the plurality of flow channels 20 are processed on the base plate 10 by using an extrusion molding method, so that the base plate 10 and the plurality of flow channels 20 have the integrated structure without milling the flow channels 20 and subsequent soldering and assembling processes. Thus, the processing technique is simple, along with less material consumption and reduced production costs. Little residue exists in the flow channels 20 formed by the extrusion molding, thereby reducing the possibility of subsequent clogging of the filter mesh. Further, the integrated structure achieves high structural strength at the junction between the flow channels 20 and the base plate 10, so that the cooling liquid will not break through the junction between the flow channels 20 and the base plate 10 due to the large flow pressure of the cooling liquid, and the leakage of the cooling liquid is avoided. Specifically, the base plate 10 is assembled with the inlet flow guide assembly 30 and the outlet flow guide assembly 40 by plugging and soldering, which reduces the thickness at the junctions between the base plate 10 and the inlet flow guide assembly 30 and the outlet flow guide assembly 40, reduces the weight of the product, and improves the performance and market competitiveness of the product.

In an embodiment of the present disclosure, preferably, as shown in FIG. 4, the heat dissipation apparatus 1 further includes corrugations 50, which are evenly distributed on inner side walls or part of the inner side walls of the plurality of flow channels 20.

In this embodiment, by providing the corrugations 50, and evenly distributing the corrugations 50 on the inner side walls or part of the inner side walls of the plurality of flow channels 20, a heat exchange area between the cooling liquid and the heat dissipation apparatus 1 is increased, and the heat dissipation efficiency of the product is enhanced. Specifically, when the cross section of the outer wall of the flow channel 20 is square, corrugations are provided on inner walls of two opposite sides of the square flow channel; certainly, the corrugations can be evenly distributed on the inner walls of the square flow channel. For another example, when the cross section of the outer wall of the flow channel 20 is pentagonal, and the corrugations are evenly distributed on any two inner walls of the pentagonal flow channel, and so on.

In a specific embodiment, the cross-sectional shape of the corrugation 50 is wavy or the cross-sectional shape of the corrugation 50 is zigzag.

In an embodiment of the present disclosure, preferably, as shown in FIG. 1 and FIG. 2, the heat dissipation apparatus 1 further includes: a flow guide groove 60 provided on a top end of the base plate 10, in which the top end refers to an end of the heat dissipation apparatus 1 connected to the devices to be heat-dissipated.

In this embodiment, the flow guide groove 60 is provided on the top end of the base plate 10, and the devices to be heat-dissipated are mounted on the top end of the heat dissipation apparatus 1, so that when the frequency converter works, condensation will occur under extreme working conditions, and at this time, the condensation will flow into the flow guide groove 60 along the devices to be heat-dissipated and then flows out of the heat dissipation apparatus 1 under the guidance of the flow guide groove 60. The structure of the flow guide groove 60 restricts the flow path of the condensation, so that the condensation can flow out of the heat dissipation apparatus 1 in accordance with a preset path, thereby ensuring a dry working environment of the devices to be heat-dissipated. Certainly, the flow guide groove 60 can be provided according to actual situations; the position thereof is not limited to the above example, and the flow guide groove 60 may not be provided on the base plate 10.

In an embodiment of the present disclosure, preferably, as shown in FIG. 1 and FIG. 2, the heat dissipation apparatus 1 further includes: a first connection hole 70 provided on the top end, a first fastener passing through the device to be heat-dissipated and being locked in the first connection hole 70 to assemble the heat dissipation apparatus 1 with the device to be heat-dissipated; and a second connection hole 80 provided on the top end, a second fastener passing through the second connection hole 80 and being locked in a casing of the frequency converter to assemble the heat dissipation apparatus 1 with the casing.

In a specific embodiment, the first connection hole 70 is a first screw hole, and the second connection hole 80 is a second screw hole.

In a specific embodiment, the casing, the heat dissipation apparatus 1, and the device to be heat-dissipated can also be assembled in the following manner. One of the top end of the base plate 10 and the device to be heat-dissipated is provided with a first snap, and the other one thereof is provided with a first snap slot, such that the heat dissipation apparatus 1 and the device to be heat-dissipated are assembled by the snapping between the first snap and the first snap slot. One of the top end of the base plate 10 and the casing is provided with a second snap, and the other one thereof is provided with a second snap slot, such that the heat dissipation apparatus 1 and the casing are assembled by the snapping between the second snap and the second snap slot. This structural configuration realizes the stable and reliable assembling of the casing, the heat dissipation apparatus 1, and the device to be heat-dissipated, and at the same time, the structural configuration facilitates installation and subsequent disassembling and maintenance.

In an embodiment of the present disclosure, preferably, as shown in FIGS. 1 and 6, the first side wall 102 and the second side wall 104 are located on two opposite sides of the base plate 10, respectively.

In this embodiment, the first side wall 102 and the second side wall 104 are arranged appropriately, so that the first side wall 102 and the second side wall 104 are located on two opposite sides of the base plate 10 respectively, thus simplifying the processing technique of the flow channels 20, reducing the bends of the flow channels 20, and increasing the density of the flow channels 20.

In a specific embodiment, the base plate 10 is a rectangular base plate, and the thickness of the base plate 10 is smaller than the width of the base plate 10, thus realizing the flattening of the base plate 10. The first side wall 102 and the second side wall 104 are two opposite sides of the base plate 10 in a width direction. Thus, the dimensions of the inlet flow guide assembly 30 and the outlet flow guide assembly 40 connected to the first side wall 102 and the second side wall 104 are reduced, thereby decreasing the material input and lowering the production cost. Certainly, the first side wall 102 and the second side wall 104 may be adjacent two side walls of the base plate 10. Specifically, the first side wall 102 and the second side wall 104 can be reasonably arranged according to positions of other devices of the frequency converter, to maximize the reasonable use of the space in the frequency converter, thereby achieving the purpose of reducing the size and weight of the frequency converter.

In a specific embodiment, the first side wall 102 of the base plate 10 and the second side wall 104 of the base plate 10 are provided with chamfers. In this way, the concentration of stress is avoided, and situations where the edge of the base plate 10 may hurt the installation personnel are avoided. Meanwhile, the arrangement of chamfers reduces the size of the first opening 304 of the base plate 10 which the collecting tube 302 is inserted into and the size of the second opening 404 of the base plate 10 which the flow guide tube 402 is inserted into, such that the soldering of the base plate 10, the inlet flow guide assembly 30, and the outlet flow guide assembly 40 is facilitated, the stacking area of the solder is enlarged, and the assembling stability and reliability is enhanced.

In a specific embodiment, the base plate 10 is a flat base plate, and the flow channel 20 is a square through-hole. A plurality of square through-holes run through the first side wall 102 and the second side wall 104 of the flat base plate 10, without overlapping each other. An inner wall of the square through-hole is evenly distributed with uneven corrugations so as to increase a heat exchange area between the cooling liquid and the heat dissipation apparatus 1. The shape of the corrugations 50 is not limited. Preferably, the corrugations are provided on inner walls on two opposite sides of the square through-hole; certainly, the corrugations 50 can also be evenly distributed on inner walls of the square through-hole.

In a specific embodiment, the shapes of the inlet flow guide assembly 30 and the outlet flow guide assembly 40 may be circular or square.

In a specific embodiment, the distribution port 308 may be a circular distribution port, which is convenient for processing. Certainly, the distribution port 308 may also be a square distribution port. The plurality of flow channels 20 are arranged side by side in a transverse direction; the plurality of distribution ports 308 are arranged side by side in the transverse direction; a plane where center lines passing through the plurality of distribution ports 308 are located is parallel to a plane where center lines passing through the plurality of flow channels 20. The transverse direction is perpendicular to a flow direction of the cooling liquid in the plurality of flow channels 20.

In a specific embodiment, the cooling liquid may be water, a refrigerant, or the like. Preferably, the cooling liquid is tetrafluoroethane.

In a specific embodiment, the flow channel 20 is configured as a linear flow channel.

As shown in FIG. 7, according to embodiments of a second aspect of the present disclosure, a frequency converter is further proposed, which includes a power module 2; and the heat dissipation apparatus 1 according to embodiments of a first aspect of the present disclosure. The power module 2 is connected with the top end of the heat dissipation apparatus 1.

Since the frequency converter provided in the present disclosure includes the heat dissipation apparatus 1 described in the embodiments of the first aspect, the frequency converter has all the beneficial effects of the heat dissipation apparatus 1 described above, which will not be elaborated in detail.

In the present disclosure, the term "a plurality of' means two or more than two, unless specified otherwise. The terms "mounted," "connected," "coupled," "fixed" and the like are used broadly, and may be, for example, fixed connections, detachable connections, or integral connections; may also be direct connections or indirect connections via intervening structures, which could be understood by those skilled in the art according to specific situations.

Reference throughout this specification to "an embodiment," "some embodiments," or "a specific embodiment," means that a particular feature, structure, material, or characteristic described in connection with the embodiment or example is included in at least one embodiment or example of the present disclosure. Thus, the above terms throughout this specification are not necessarily referring to the same embodiment or example of the present disclosure. Furthermore, the particular features, structures, materials, or characteristics may be combined in any suitable manner in one or more embodiments or examples.

The above embodiments are merely preferable embodiments of the present disclosure and are not intended to limit the present disclosure. It would be appreciated by those skilled in the art that various modifications and changes can be made in the present disclosure. Any modifications, alternatives, and improvements without departing from the principles of the present disclosure should be contained in the protection scope of the present disclosure.

## Claims

1. A heat dissipation apparatus for a frequency converter, comprising:
a base plate;
a plurality of flow channels provided in the base plate, and penetrating a first side wall and a second side wall of the base plate, without overlapping each other;
an inlet flow guide assembly connected to the first side wall and communicated with the plurality of flow channels; and
an outlet flow guide assembly connected to the second side wall and communicated with the plurality of flow channels.

2. The heat dissipation apparatus according to claim 1, wherein the inlet flow guide assembly comprises:
a collecting tube, the first side wall being inserted in a first opening of the collecting tube;
a distribution tube having a first end penetrating the collecting tube;
a plurality of distribution ports provided in the distributing tube and arranged corresponding to the first opening;
a first end cap covering a first end of the collecting tube, the first end of the distribution tube abutting against an inner bottom wall of the first end cap; and
a second end cap passing through a second end of the distribution tube and covering a second end of the collecting tube.

3. The heat dissipation apparatus according to claim 2, wherein the first end cap is provided with a two-step groove recessed in a direction away from the collecting tube, an end surface of an end of the collecting tube abuts against a stepped surface of the two-step groove, and an end surface of an end of the distribution tube abuts against an inner bottom wall of a secondary groove of the two-step groove;
wherein a flange is provided at a junction between an outer wall of the second end cap and the distribution tube.

4. The heat dissipation apparatus according to any one of claims 1 to 3, wherein the outlet flow guide assembly comprises:
a flow guide tube, the second side wall being inserted in a second opening of the flow guide tube; and
a third end cap covering a first end of the flow guide tube.

5. The heat dissipation apparatus according to any one of claims 1 to 4, wherein the base plate and the plurality of flow channels are of an integrated structure.

6. The heat dissipation apparatus according to any one of claims 1 to 5, further comprising corrugations evenly distributed on inner side walls or on a part of the inner side walls of the plurality of flow channels.

7. The heat dissipation apparatus according to any one of claims 1 to 6, further comprising a flow guide groove provided on a top end of the base plate, wherein the top end is an end of the heat dissipation apparatus connected to a device to be heat-dissipated.

8. The heat dissipation apparatus according to claim 7, further comprising:
a first connection hole provided in the top end, a first fastener passing through the device to be heat-dissipated and being locked in the first connection hole, so as to assemble the heat dissipation apparatus and the device to be heat-dissipated together; and
a second connection hole provided in the top end, a second fastener passing through the second connection hole and being locked in a casing of a frequency converter, so as to assemble the heat dissipation apparatus and the casing together.

9. The heat dissipation apparatus according to any one of claims 1 to 8, wherein the first side wall and the second side wall are located on two opposite sides of the base plate respectively.

10. A frequency converter, comprising:
a power module; and
a heat dissipation apparatus according to any one of claims 1 to 9, the power module being connected to a top end of the heat dissipation apparatus.
